# EUROPÄISCHE PATENTANMELDUNG

(11) **EP 0 895 360 A2**
(43) Veröffentlichungstag der Anmeldung: **03.02.1999**
(21) Anmeldenummer: 98105683.1
(22) Anmeldetag: 28.03.1998
(51) Int. Cl.: H03M 1/30, G01D 5/30

(54) **Optischer Inkrementgeber**

(30) Priorität: 31.07.1997 DE 19733049
(71) Anmelder: ROBERT BOSCH GMBH, 70442 Stuttgart (DE)
(72) Erfinder: Black, Karl-Heinz, 31139 Hildesheim (DE)

(57) **Zusammenfassung**

Es wird ein optischer Inkrementgeber (1) vorgeschlagen, der eine berührungslose Bedienung einer Gerätefunktion ermöglicht. Der optische Inkrementgeber (1) umfaßt ein eine Drehachse (5) aufweisendes Inkrementrad (10), zwei Lichtempfänger (15, 20) und zwei Lichtsender (25, 30), wobei jeweils einer der Lichtsender (25, 30) und einer der Lichtempfänger (15, 20) einander zugeordnet sind und die Lichtempfänger (15, 20) in Abhängigkeit der Drehrichtung bei Betätigung des Inkrementrades (10) phasenverschoben Signalimpulse abgeben. Das Inkrementrad (10) weist hellere Flächen (45) und dunklere Flächen (50) auf. Die Lichtsender (25, 30) und die Lichtempfänger (15, 20) sind so angeordnet, daß die Lichtsender (25, 30) jeweils Licht auf eine der Flächen (45, 50) abstrahlen und die Lichtempfänger (15, 20) das von den Flächen (45, 50) reflektierte Licht des ihnen jeweils zugeordneten Lichtsenders (25, 30) empfangen. Die Lichtempfänger (15, 20) detektieren bei einer Drehung des Inkrementrades (10) in Abhängigkeit der Drehrichtung phasenverschoben abwechselnd hellere Flächen (45) und dunklere Flächen (50).

## Beschreibung

### Stand der Technik

Die Erfindung geht von einem optischen Inkrementgeber nach der Gattung des Hauptanspruchs aus.

Aus einem Prospekt der Firma Lorlin Electronics sind bereits die optischen Inkrementgeber LOE1 und LOE8 bekannt, die einen Drehregler aufweisen, der verschiedene Schaltpositionen einnehmen kann. Dabei sind mindestens 2 Leuchtdioden und zugehörige Lichtempfänger vorgesehen, wobei die Lichtempfänger bei Betätigung des Drehreglers Signalimpulsfolgen abgeben, die je nach Drehrichtung um 90° phasenverschoben sind.

### Vorteile der Erfindung

Der erfindungsgemäße optische Inkrementgeber mit den Merkmalen des Hauptanspruchs hat demgegenüber den Vorteil, daß kein eigenständiges Bauelement mit einer Drehachse zur Aufnahme der Drehbewegung des Inkrementrades auf einer Leiterplatte vorzusehen ist, so daß bei der Betätigung des Inkrementrades keine mechanischen Kräfte auf die Leiterplatte übertragen werden. Auf diese Weise wird die Leiterplatte durch Betätigung des Inkrementrades mechanisch nicht beansprucht.

Ein weiterer Vorteil besteht darin, daß auch die Erfassung von Einstellungen des Inkrementrades keine mechanische Beanspruchung erfordert, da sie berührungslos über Lichtempfänger erfolgt.

Ein weiterer Vorteil besteht darin, daß die Lichtempfänger bei einer Drehung des Inkrementrades in Abhängigkeit der Drehrichtung phasenverschoben abwechselnd hellere und dunklere Flächen detektieren. Somit ist eine Bestimmung der Drehrichtung des betätigten Inkrementrades möglich.

Durch die in den Unteransprüchen aufgeführten Maßnahmen sind vorteilhafte Weiterbildungen und Verbesserungen des im Hauptanspruchs angegebenen optischen Inkrementgebers möglich.

Besonders vorteilhaft ist es, die einander zugeordneten Lichtsender und Lichtempfänger jeweils als bauliche Lichtsende-/-empfangseinheit auszubilden, wodurch Platz, Herstellungsaufwand und -kosten eingespart werden.

Ein weiterer Vorteil besteht darin, daß das Inkrementrad konzentrisch zur Drehachse zwei ringförmige Reflektoren aufweist, die unterschiedlich von der Drehachse beabstandet sind, daß jedem Reflektor genau einer der beiden Lichtsender und genau einer der beiden Lichtempfänger zugeordnet sind wobei der jeweilige Lichtsender Licht auf den ihm zugeordneten Reflektor abstrahlt und der zugehörige Lichtempfänger das von diesem Reflektor reflektierte Licht des zugeordneten Lichtsenders empfängt, daß die Reflektoren konzentrisch zur Drehachhse jeweils eine Kodierspur aufweisen und daß auf den Kodierspuren die helleren Flächen und die dunkleren Flächen abwechselnd angeordnet sind. Auf diese Weise läßt sich eine phasenverschobene Detektion von abwechselnd helleren und dunkleren Flächen in Abhängigkeit der Drehrichtung besonders einfach und aufwandsarm realisieren, indem lediglich zwei Kodierspuren auf das Inkrementrad aufgebracht und die Lichtsender und -empfänger entsprechend angeordnet werden müssen.

Ein weiterer Vorteil besteht darin, daß die Lichtsende-/-empfangseinheiten auf einer gemeinsamen Radialen zur Drehachse liegen und daß die Codierspuren gegeneinander phasenverschoben am Inkrementrad angeordnet sind. Auf diese Weise läßt sich die für die Bestimmung der Drehrichtung bei Betätigung des Inkrementrades erforderliche phasenverschobene Detektion des reflektierten Lichtes bei den Lichtempfängern besonders einfach und präzise realisieren.

Vorteilhaft ist auch, daß die beiden Codierspuren die gleiche Anzahl von helleren Flächen und dunkleren Flächen aufweisen. Dadurch läßt sich die Herstellung der Kodierspuren vereinfachen und vereinheitlichen.

Ein weiterer Vorteil besteht darin, daß das Inkrementrad konzentrisch zur Drehachse genau einen ringförmigen Reflektor aufweist, das dem Reflektor die beiden Lichtsender und die beiden Lichtempfänger zugeordnet sind, wobei die beiden Lichtsender Licht auf den Reflektor abstrahlen und die beiden Lichtempfänger das vom Reflektor reflektierte Licht des ihnen jeweils zugeordneten Lichtsenders empfangen, daß der Reflektor konzentrisch zur Drehachse eine Kodierspur aufweist und daß auf der Kodierspur die helleren Flächen und die dunkleren Flächen abwechselnd angeordnet sind. Auf diese Weise kann eine Kodierspur eingespart werden, wodurch der Herstellungsaufwand für den optischen Inkrementgeber weiter verringert wird.

Eine phasenverschobene Detektion des jeweils reflektierten Lichtes durch die Lichtempfänger kann auch dadurch erreicht werden, daß die Lichtsender und die Lichtempfänger so angeordnet sind, daß die Lichtempfänger nicht gleichzeitig an derselben Radialen zur Drehachse des Inkrementrades reflektiertes Licht detektieren. Auch auf diese Weise läßt sich somit die zur Bestimmung der Drehrichtung bei Betätigung des Inkrementrades erforderliche phasenverschobene Detektion des jeweils reflektierten Lichtes an den Lichtempfängern einfach und präzise realisieren.

Vorteilhaft ist auch, daß die helleren Flächen und die dunkleren Flächen auf das Inkrementrad aufgedruckt sind, da ein solcher Druckvorgang sehr präzise und preiswert durchgeführt werden kann.

Vorteilhaft ist auch, daß das Inkrementrad zentrisch zur Drehachse eine Bohrung aufweist und daß in der Bohrung eine vorzugsweise beleuchtbare Drucktaste angeordnet ist, über die ein Druckkontakt betätigbar ist. Auf diese Weise wird die Funktionalität des Inkrementrades erhöht, so daß über die Drucktaste des Inkrementrades beispielsweise ein Ein- bzw. Ausschalter realisierbar ist. Da keine störende, mit der Leiterplatte verbundene Achse vorhanden ist, läßt sich der Druckkontakt ohne großen Aufwand einfach auf der Leiterplatte unterhalb der Drucktaste anordnen. Durch die Bohrung wird auch verhindert, daß durch Betätigung der Drucktaste die Reflektoren bewegt werden, so daß bei Betätigung der Drucktaste eine mechanische Beanspruchung der Reflektoren des Inkrementrades vermieden wird.

Außerdem wird die Funktionalität der Drucktaste erhöht, da sie gleichzeitig als Achse für die Drehbewegung des Inkrementrades dient.

Vorteilhaft ist auch, wenn die Drucktaste beleuchtbar ausgeführt ist. Dadurch wird die Bedienung für den Benutzer, vor allem bei Nacht erleichtert.

Ein weiterer Vorteil besteht darin, daß die helleren Flächen und die dunkleren Flächen einer Codierspur jeweils gleich groß sind. Auf diese Weise läßt sich die Herstellung der Codierspuren vereinfachen.

### Zeichnung

Ausführungsbeispiele der Erfindung sind in der Zeichnung dargestellt und in der nachfolgenden Beschreibung näher erläutert. Es zeigen Figur 1 einen erfindungsgemäßen optischen Inkrementgeber gemäß einem ersten Ausführungsbeispiel, Figur 2 einen erfindungsgemäßen optischen Inkrementgeber gemäß einem zweiten Ausführungsbeispiel, Figur 3 einen erfindungsgemäßen optischen Inkrementgeber gemäß einem dritten Ausführungsbeispiel, Figur 4 ein Blockschaltbild eines erfindungsgemäßen optischen Inkrementgebers, Figur 5 einen Verlauf der Ausgangssignale der Lichtempfänger des erfindungsgemäßen optischen Inkrementgebers und Figur 6 einen Ablaufplan für die Auswertung der Ausgangssignale der Lichtempfänger in einer Auswerteschaltung.

### Beschreibung der Ausführungsbeispiele

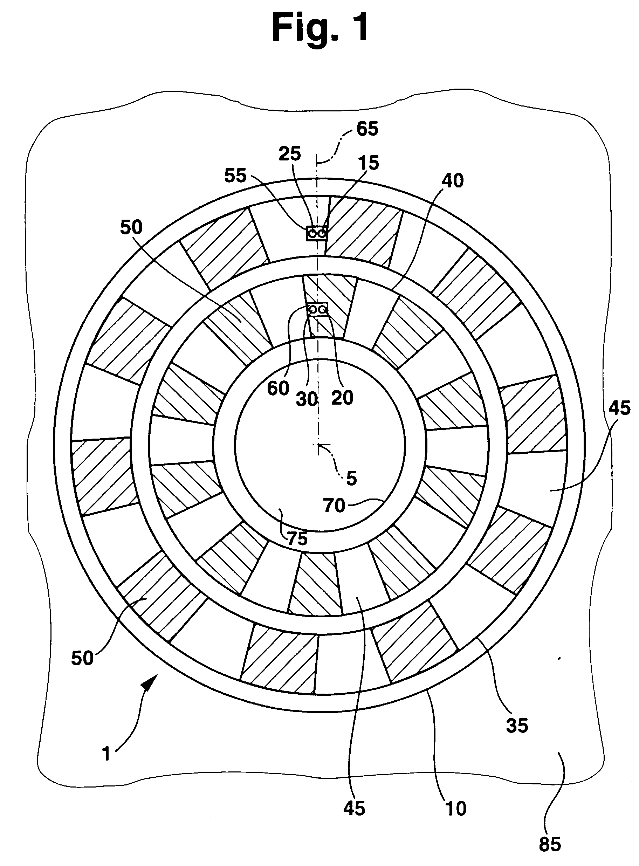

In Figur 1 kennzeichnet 1 einen optischen Inkrementgeber, der beispielsweise für die Lautstärkeeinstellung eines Autoradios verwendbar ist, generell jedoch für die inkrementale Einstellung von Werten beliebiger Funktionen an beliebigen elektrischen Geräten. Der optische Inkrementgeber 1 umfaßt ein an einer Gerätekappe 85 angeordnetes Inkrementrad 10 mit einer Drehachse 5, die senkrecht zur Gerätekappe 85 an der Gerätekappe 85 angeordnet ist. Das Inkrementrad 10 ist um die Drehachse 5 drehbar an der Gerätekappe 85 gelagert. An seiner der Gerätekappe 85 zugewandten Oberfläche weist das Inkrementrad 10 konzentrisch zur Drehachse 5 einen ersten ringförmigen Reflektor 35 und einen zweiten ringförmigen Reflektor 40 auf, wobei der erste ringförmige Reflektor 35 weiter von der Drehachse 5 beabstandet ist, als der zweite ringförmige Reflektor 40 und die beiden ringförmigen Reflektoren 35, 40 nicht überlappen, sondern durch einen Abstand voneinander getrennt sind. Die Reflektoren 35, 40 sind jeweils als konzentrisch zur Drehachse 5 ausgebildete Codierspuren mit abwechselnd helleren Flächen 45 und dunkleren Flächen 50 ausgebildet. Dabei sind die helleren Flächen 45 und die dunkleren Flächen 50 einer Codierspur 35, 40 gleich groß. Außerdem weisen die beiden Codierspuren 35, 40 die gleiche Anzahl von helleren Flächen 45 und dunkleren Flächen 50 auf. Die Abwechslung der helleren Flächen 45 mit den dunkleren Flächen 50 ist dabei jeweils in tangentialer, nicht in radialer Richtung realisiert. Die beiden Codierspuren 35, 40 sind im Ausführungsbeispiel gemäß Figur 1 um 90° gegeneinander phasenverschoben am Inkrementrad 10 angeordnet. Andere Phasenverschiebungen sind ebenfalls möglich, ausgenommen jedoch eine Phasenverschiebung um 0 bzw. um 180°. Bei den beiden letztgenannten Phasenverschiebungswinkeln läßt sich eine Detektion der Drehrichtung bei Betätigung des Inkrementrades 10 nicht mehr gewährleisten. Auf einer Radialen 65 zur Drehachse 5 liegen zwei Lichtsende-/-empfangseinheiten 55, 60, die jeweils als bauliche Einheit eines Lichtsenders 25, 30 und eines Lichtempfängers 15, 20 ausgebildet sind. So bildet ein erster Lichtsender 25 mit einem ersten Lichtempfänger 15 eine erste Lichtsende-/-empfangseinheit 55 und ein zweiter Lichtsender 30 und ein zweiter Lichtempfänger 20 bilden eine zweite Lichtsende-/-empfangseinheit 60. Die erste Lichtsende-/empfangseinheit 55 ist dabei weiter von der Drehachse 5 entfernt als die zweite Lichtsende-/empfangseinheit 60. Die erste Lichtsende-/-empfangseinheit 55 wird dabei vom ersten Reflektor 35 überdeckt und die zweite Lichtsende-/-empfangseinheit 60 wird vom zweiten Reflektor 40 überdeckt. Die erste Lichtsende-/-empfangseinheit 55 ist somit dem ersten Reflektor 35 zugeordnet, und die zweite Lichtsende-/-empfangseinheit 60 ist dem zweiten Reflektor 40 zugeordnet. Die beiden Lichtsende-/-empfangseinheiten 55, 60 sind an der dem Inkrementrad 10 zugewandten Seite auf einer in Figur 1 nicht dargestellten Leiterplatte angeordnet, die sich auf der dem Inkrementrad 10 abgewandten Seite der Gerätekappe 85 befindet. Über entsprechende Durchbrüche der Gerätekappe 85 sind die beiden Lichtsende-/-empfangseinheiten 55, 60 an der Gerätekappe 85 zugänglich. Somit ist dem ersten Reflektor 35 der erste Lichtsender 25 und der erste Lichtempfänger 15 zugeordnet, und dem zweiten Reflektor 40 ist der zweite Lichtsender 30 und der zweite Lichtempfänger 20 zugeordnet. Der dem jeweiligen Reflektor 35, 40 zugeordnete Lichtsender 25, 30 strahlt Licht auf diesen Reflektor 35, 40 ab. Dort wird es reflektiert und von dem dem jeweiligen Reflektor 35, 40 zugeordneten Lichtempfänger 15, 20 empfangen. In der Stellung des Inkrementrades 10 gemäß Figur 1 empfängt der erste Lichtempfänger 15 das von einer helleren Fläche 45 reflektierte Licht, wohingegen aufgrund der Phasenverschiebung der beiden Codierspuren 35, 40 um 90° der zweite Lichtempfänger 20 das von einer dunkleren Fläche 50 reflektierte Licht empfängt.

Das Inkrementrad 10 kann zusätzlich zentrisch zur Drehachse 5 eine Bohrung 70 aufweisen, wobei in der Bohrung 70 eine Drucktaste 75 angeordnet ist, über die ein Druckkontakt beispielsweise zum Ein-/Ausschalten des Gerätes oder der speziellen durch das Inkrementrad 10 bedienbaren Funktion betätigbar ist. Das Inkrementrad 10 ist dabei um die vorzugsweise zylinderförmige Drucktaste 75 an der Gerätekappe 85 gelagert.

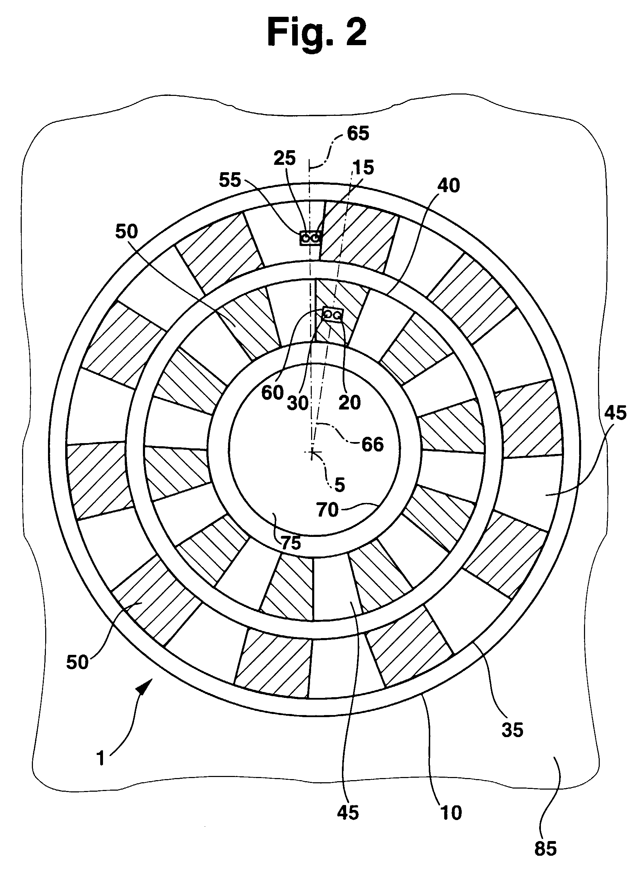

In Figur 2 ist ein weiteres Ausführungsbeispiel des erfindungsgemäßen optischen Inkrementgebers 1 dargestellt, wobei gleiche Bezugszeichen gleiche Elemente kennzeichnen. Im Unterschied zum Ausführungsbeispiel gemäß Figur 1 sind die Codierspuren 35, 40 nicht gegeneinander phasenverschoben. Jedoch liegen die erste und die zweite Lichtsende-/-empfangseinheit 55, 60 nicht auf derselben Radialen zur Drehachse 5. Vielmehr ist die erste Lichtsende-/-empfangseinheit 55 an einer ersten Radialen 65 und die zweite Lichtsende-/-empfangseinheit 60 an einer zweiten Radialen 66 angeordnet.

Auf diese Weise sind die den Reflektoren 35, 40 zugeordneten Lichtsender 25, 30 und Lichtempfänger 15, 20 so angeordnet, daß jeder der beiden Lichtempfänger 15, 20 an einer unterschiedlichen Radialen 65, 66 zur Drehachse 5 des Inkrementrades 10 reflektiertes Licht detektiert. Die beiden Radialen 65, 66 zur Drehachse 5 für die Anordnung der Lichtsende-/-empfangseinheiten 55, 60 gemäß Figur 2 sind dabei so gewählt, daß die entsprechenden Lichtempfänger 15, 20 die helleren Flächen 45 und die dunkleren Flächen 50 mit einer Phasenverschiebung von 90° detektieren. Dabei nimmt das Inkrementrad 10 gemaß Figur 2 eine momentane Stellung ein, in der der erste Lichtempfänger 15 eine hellere Fläche 45 detektiert und der zweite Lichtempfänger 20 eine dunklere Fläche 50.

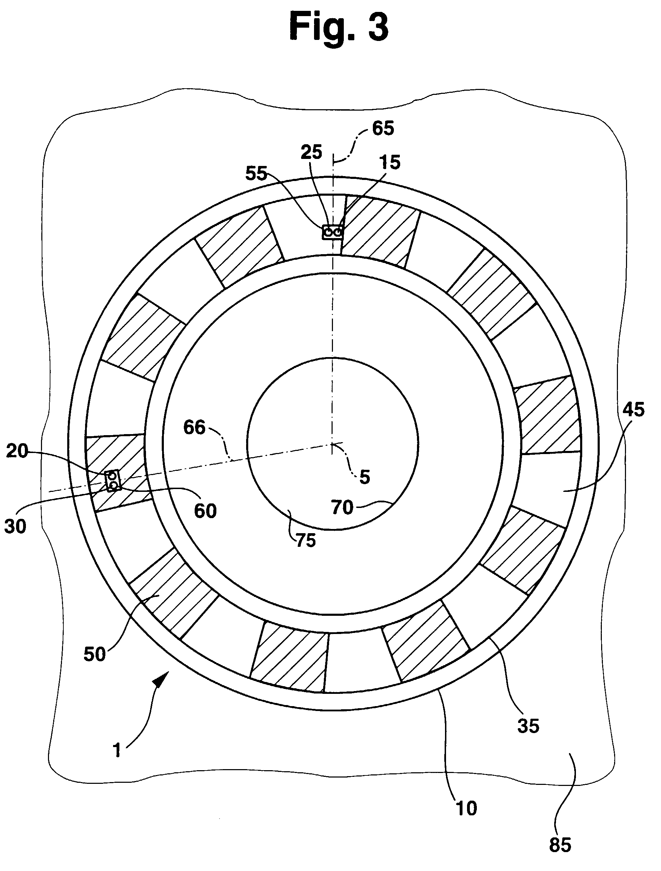

In Figur 3 ist ein weiteres Ausführungsbeispiel des erfindungsgemäßen optischen Inkrementgebers 1 dargestellt, wobei gleiche Bezugszeichen gleiche Elemente kennzeichnen. Im Unterschied zu den beiden vorherigen Ausführungsbeispielen gemäß den Figuren 1 und 2 weist das Inkrementrad 10 beim Ausführungsbeispiel gemäß Figur 3 genau einen Reflektor 35 auf. Außerdem ist sowohl die erste Lichtsende-/-empfangseinheit 55 als auch die zweite Lichsende-/-empfangseinheit 60 diesem Reflektor 35 zugeordnet. Das bedeutet, daß sowohl der erste Lichtsender 25 als auch der zweite Lichtsender 30 Licht auf den Reflektor 35 abstrahlen, von wo es reflektiert und von dem dem jeweiligen Lichtsender 25, 30 zugeordneten Lichtempfänger 15, 20 empfangen wird. Analog zum Ausführungsbeispiel gemäß Figur 2 liegt beim Ausführungsbeispiel gemäß Figur 3 die erste Lichtsende-/-empfangseinheit 55 auf einer ersten Radialen 65 zur Drehachse 5 und die zweite Lichtsende-/-empfangseinheit 60 auf einer zweiten, von der ersten Radialen 65 verschiedenen Radialen 66 zur Drehachse 5. Auch beim Ausführungsbeispiel gemäß Figur 3 sind die beiden Radialen 65,66 zur Drehachse 5 für die Anordnung der Lichtsende-/-empfangseinheiten 55, 60 so gewählt, daß die entsprechenden Lichtempfänger 15, 20 die helleren Flächen 45 und die dunkleren Flächen 50 mit einer Phasenverschiebung von 90° detektieren. Dabei nimmt das Inkrementrad 10 gemäß Figur 3 eine momentane Stellung ein, in der der erste Lichtempfänger 15 eine hellere Fläche 45 detektiert und der zweite Lichtempfänger 20 eine dunklere Fläche 50.

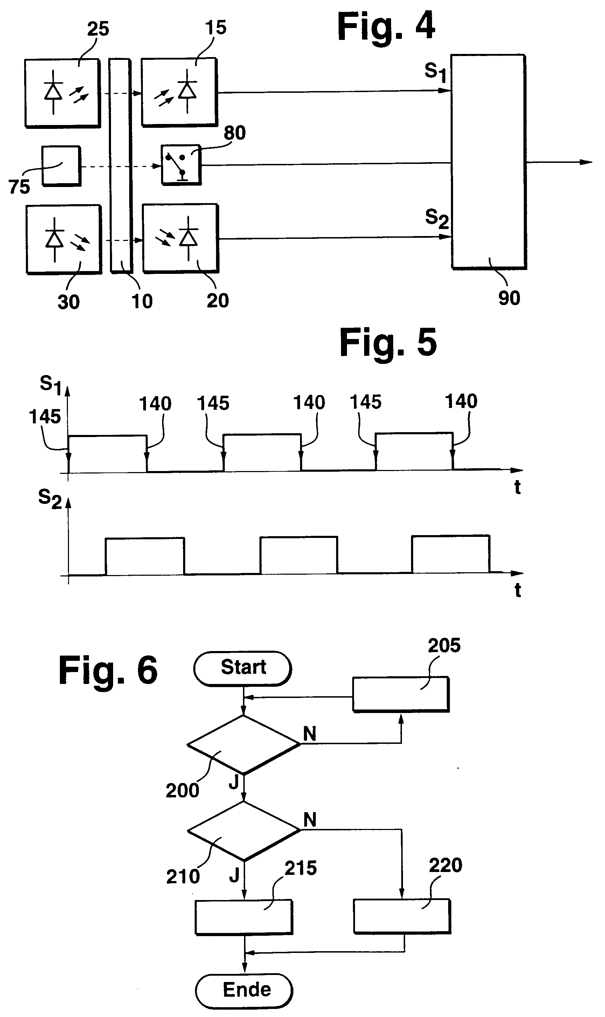

In einem Blockschaltbild gemäß Figur 4 sind der erste Lichtsender 25 und der zweite Lichtsender 30 als Leuchtdioden dargestellt. Es können jedoch auch andere Lichtsender, beispielsweise Laserdioden verwendet werden. Als Lichtempfänger 15, 20 sind in Figur 4 Fotodioden dargestellt. Es können jedoch auch andere Lichtempfänger, beispielswiese Fototransistoren verwendet werden. Als Wellenlängenbereich für die Lichtsender 25, 30 und die Lichtempfänger 15, 20 kann beispielsweise der Infrarotbereich gewählt werden. Durch Reflexion an dem Inkrementrad 10 gelangt das vom ersten Lichtsender 25 abgestrahlte Licht an den ersten Lichtempfänger 15, und das vom zweiten Lichtsender 30 abgestrahlte Licht an den zweiten Lichtempfänger 20. Der erste Lichtempfänger 15 wandelt das zugeführte Lichtsignal in ein erstes impulsförmiges elektrisches Ausgangssignal S₁ um. Der zweite Lichtempfänger 20 wandelt das ihm zugeführte Lichtsignal in ein zweites impulsförmiges elektrisches Ausgangssignal S₂ um. Das erste und das zweite Ausgangssignal S₁ und S₂ wird jeweils einer Auswerteschaltung 90 zugeführt, die aufgrund der beiden Ausgangssignale S₁, S₂ die Drehrichtung des Inkrementrades 10 und die Anzahl der durchzuführenden Inkrementierungsschritte ermittelt. Die Auswerteschaltung 90 veranlaßt daraufhin eine entsprechende Einstellung der durch das Inkrementrad 10 bedienbaren Gerätefunktion. Dies ist durch einen am Ausgang der Auswerteschaltung 90 angedeuteten, von der Auswerteschaltung 90 wegweisenden Pfeil angedeutet. Der über die Drucktaste 75 betätigbare Druckkontakt 80 ist ebenfalls an die Auswerteschaltung 90 angeschlossen und ermöglicht das Ein-/Ausschalten des entsprechenden elektrischen Gerätes bzw. der durch das Inkrementrad 10 zu bedienenden Funktion des elektrischen Gerätes.

In Figur 5 ist ein Verlauf der beiden Ausgangssignale S₁, S₂ jeweils über der Zeit t dargestellt. Für den Fall, daß eine hellere Fläche 45 detektiert wird, gibt der entsprechende Lichtempfänger 15, 20 als Ausgangssignal S₁, S₂ einen Impuls ab. Für den Fall, daß eine dunklere Fläche 50 detektiert wird, gibt der entsprechende Lichtempfänger 15, 20 kein Ausgangssignal S₁, S₂ ab. Wird das Inkrementrad 10 gemäß Figur 1, Figur 2 oder Figur 3 im Uhrzeigersinn gedreht, so ergibt sich der zeitliche Verlauf gemäß Figur 5. Bei konstanter Drehgeschwindigkeit ergibt sich dabei aufgrund der gleichen Abmessungen der dunkleren Flächen 50 und der helleren Flächen 45 eine periodische Impulsfolge für die Ausgangssignale S₁, S₂, die gegeneinander um 90° phasenverschoben sind. Dabei eilt das zweite Ausgangssignal S₂ dem ersten Ausgangssignal S₁ um 90° nach. Bei Drehung im Uhrzeigersinn werden die Diagramme gemäß Figur 5 von links nach rechts mit zunehmender Zeit durchlaufen. Bei Drehung gegen den Uhrzeigersinn werden die beiden Diagramme von rechts nach links mit zunehmender Zeit durchlaufen. Dann eilt das erste Ausgangssignal S₁ dem zweiten Ausgangssignal S₂ um 90° nach. Aus der Anzahl der bei einem Drehvorgang des Inkrementrades 10 detektierten Impulse des ersten Ausgangssignals S₁ ermittelt die Auswerteschaltung 90 die Anzahl der durchzuführenden Inkrementierungsschritte. Eine Bewegung des Inkrementrades 10 im Uhrzeigersinn ist dann beispielsweise mit einer entsprechend inkrementalen Erhöhung des zugeordneten Funktionswertes, beispielsweise der Lautstärke des Autoradios verbunden. Eine Bewegung des Inkrementrades 10 gegen den Uhrzeigersinn ist dann mit einer entsprechend inkrementalen Verringerung des zugeordneten Funktionswertes verbunden.

Gemäß Figur 6 ist ein Ablaufplan dargestellt, der die Detektion der Drehbewegung des Inkrementrades 10 in der Auswerteschaltung 90 auf der Grundlage des Impulsfahrplans gemäß Figur 5 beschreibt. Das in Figur 6 dargestellte Programm wird dabei für jeden einzelnen Inkrementierungsvorgang erneut durchlaufen. Bei einem Programmpunkt 200 wird geprüft, ob das erste Ausgangssignal S₁ des ersten Lichtempfängers 15 eine fallende Flanke 140, 145 gemäß Figur 5 aufweist. Ist dies der Fall, so wird zum Programmpunkt 210 verzweigt, anderenfalls wird zum Programmpunkt 205 verzweigt, bei Programmpunkt 205 wird eine Warteschleife durchlaufen und anschließend wird wieder zu Programmpunkt 200 verzweigt. Bei Programmpunkt 210 wird geprüft, ob bei der detektierten fallenden Flanke 140, 145 das zweite Ausgangssignal S₂ des zweiten Lichtempfängers 20 eingeschaltet ist, das heißt, ob dort bei der fallenden Flanke 140, 145 ein Impuls vorliegt. Ist dies der Fall, so wird zu Programmpunkt 215 verzweigt, anderenfalls wird zu Programmpunkt 220 verzweigt. Bei Programmpunkt 215 ist eine Drehbewegung des Inkrementrades 10 im Uhrzeigersinn detektiert worden, so daß bei diesem Programmpunkt eine Inkrementierung der Einstellung der entsprechenden Bedienfunktion erfolgt. Handelt es sich bei der einzustellenden Bedienfunktion beispielsweise um die Lautstärke des Autoradios, so wird diese bei Programmpunkt 215 inkremental erhöht. Gemäß Figur 5 wird eine fallende Flanke des ersten Ausgangssignals S₁ des ersten Lichtempfängers 15 mit dem Bezugszeichen 140 gekennzeichnet, wenn bei dieser fallenden Flanke das zweite Ausgangssignal S₂ des zweiten Lichtempfängers 20 eingeschaltet ist bzw. an dessen Ausgang ein Impuls vorliegt. Bei einer Drehbewegung des Inkrementrades 10 gegen den Uhrzeigersinn werden die beiden Diagramme gemäß Figur 5 von rechts nach links durchlaufen. Eine abfallende Flanke des ersten Ausgangssignals S₁ des ersten Lichtempfängers 15 fällt dann mit einem ausgeschalteten zweiten Ausgangssignal S₂ des zweiten Lichtempfängers 20 zusammen und wird durch das Bezugszeichen 145 gekennzeichnet. Eine solche fallende Flanke 145 bei ausgeschaltetem zweiten Ausgangssignal S₂ des zweiten Lichtempfängers 20 wurde bei Programmpunkt 220 detektiert, so daß bei Programmpunkt 220 eine Drehbewegung des Inkrementrades 10 gegen den Uhrzeigersinn detektiert wurde. Dies führt dann zu einer Dekrementierung der Einstellung der entsprechend zugehörigen Bedienfunktion, das heißt im Beispiel der Lautstarke des Autoradios zu einer entsprechenden Verringerung dieser Lautstärke. Nach Programmpunkt 215 bzw. Programmpunkt 220 wird das Programm verlassen.

Alternativ könnten die Rollen des ersten Ausgangssignals S₁ und des zweiten Ausgangssignals S₂ bei der Auswertung in der Auswerteschaltung 90 auch vertauscht werden. Genausogut kann eine Inkrementierung der Einstellung der entsprechenden Bedienfunktion auch durch Drehung des Inkrementrades 10 gegen den Uhrzeigersinn und eine Dekrementierung durch Drehbewegung des Inkrementrades 10 im Uhrzeigersinn realisiert werden.

Die Erkennung der Drehrichtung des Inkrementrades 10 beruht also auf der in Abhängigkeit der Drehrichtung bei Betätigung des Inkrementrades 10 phasenverschobenen Detektion der helleren Flächen 45 und der dunkleren Flächen 50 durch die Lichtempfänger 15, 20, so daß die Lichtempfänger 15, 20 in Abhängigkeit der Drehrichtung entsprechend phasenverschoben Signalimpulse abgeben.

Wählt man für die Lichtempfänger 15, 20 eine kurze Ansprechzeit, so werden auch schnelle Drehbewegungen des Inkrementrades 10 detektiert.

Auf Aufbringen der Codierspuren 35, 40 auf das Inkrementrad 10 kann beispielsweise durch einen Druckvorgang erfolgen.

Die Drucktaste 75 kann beleuchtbar ausgeführt werden, indem sie aus lichtdurchlässigem Material gebildet wird und im Innern mit einer Lichtquelle versehen wird. Dies erleichtert die Bedienung vor allem bei Dunkelheit.

Für den Fall, daß das Inkrementrad 10 gemäß den Ausführungsbeispielen nach Figur 1, Figur 2 und Figur 3 die Bohrung 70 mit der Drucktaste 75 aufweist, wird das Inkrementrad 10 um die gemäß den Figuren 1, 2 und 3 zylinderförmig ausgebildete Drucktaste 75 bei der Bedienung gedreht. Das Inkrementrad 10 ist dann an der Gerätekappe 85 drehbar um die Drucktaste 75 gelagert. Die Drucktaste 75 muß sich dabei nicht mitdrehen. Für den Fall, daß keine Bohrung 70 und keine Drucktaste 75 vorgesehen sind, ist an der Stelle der Drehachse 5 eine Achse vorzusehen, um die das Inkrementrad 10 drehbar an der Gerätekappe 85 gelagert ist.

## Patentansprüche

1. Optischer Inkrementgeber (1) mit einem eine Drehachse (5) aufweisenden Inkrementrad (10), zwei Lichtempfängern (15, 20) und zwei Lichtsendern (25, 30), wobei jeweils einer der Lichtsender (25, 30) und einer der Lichtempfänger (15, 20) einander zugeordnet sind und die Lichtempfänger (15, 20) in Abhängigkeit der Drehrichtung bei Betätigung des Inkrementrades (10) phasenverschoben Signalimpulse abgeben, dadurch gekennzeichnet, daß das Inkrementrad (10) hellere Flächen (45) und dunklere Flächen (50) aufweist, daß die Lichtsender (25, 30) und die Lichtempfänger (15, 20) so angeordnet sind, daß die Lichtsender (25, 30) jeweils Licht auf eine der Flächen (45, 50) abstrahlen und die Lichtempfänger (15, 20) das von den Flächen (45, 50) reflektierte Licht des ihnen jeweils zugeordneten Lichtsenders (25, 30) empfangen und daß die Lichtempfänger (15, 20) bei einer Drehung des Inkrementrades (10) in Abhängigkeit der Drehrichtung phasenverschoben abwechselnd hellere Flächen (45) und dunklere Flächen (50) detektieren.

2. Optischer Inkrementgeber (1) nach Anspruch 1, dadurch gekennzeichnet, daß die einander zugeordneten Lichtsender (25, 30) und Lichtempfänger (15, 20) jeweils eine bauliche Lichtsende-/-empfangseinheit (55, 60) bilden.

3. Optischer Inkrementgeber (1) nach Anspruch 1 oder 2, dadurch gekennzeichnet, daß das Inkrementrad (10) konzentrisch zur Drehachse (5) zwei ringförmige Reflektoren (35, 40) aufweist, die unterschiedlich von der Drehachse (5) beabstandet sind, daß jedem Reflektor (35, 40) genau einer der beiden Lichtsender (25, 30) und genau einer der beiden Lichtempfänger (15, 20) zugeordnet sind, wobei der jeweilige Lichtsender (25, 30) Licht auf den ihm zugeordneten Reflektor (35, 40) abstrahlt und der zugehörige Lichtempfänger (15, 20) das von diesem Reflektor (35, 40) reflektierte Licht des zugeordneten Lichtsenders (25, 30) empfängt, daß die Reflektoren (35, 40) konzentrisch zur Drehachse (5) jeweils eine Kodierspur aufweisen und daß auf den Kodierspuren die helleren Flächen (45) und die dunkleren Flächen (50) abwechselnd angeordnet sind.

4. Optischer Inkrementgeber (1) nach Anspruch 3, dadurch gekennzeichnet, daß die Kodierspuren gegeneinander phasenverschoben am Inkrementrad (10) angeordnet sind.

5. Optischer Inkrementgeber (1) nach Anspruch 3 oder 4, dadurch gekennzeichnet, daß die beiden Kodierspuren die gleiche Anzahl von helleren Flächen (45) und dunkleren Flächen (50) aufweisen.

6. Optischer Inkrementgeber (1) nach Anspruch 3, 4 oder 5, dadurch gekennzeichnet, daß die Lichtsende-/-empfangseinheiten (55, 60) auf einer gemeinsamen Radialen (65) zur Drehachse (5) liegen.

7. Optischer Inkrementgeber (1) nach Anspruch 1 oder 2, dadurch gekennzeichnet, daß das Inkrementrad (10) konzentrisch zur Drehachse (5) genau einen ringförmigen Reflektor (35) aufweist, daß dem Reflektor (35) die beiden Lichtsender (25, 30) und die beiden Lichtempfänger (15, 20) zugeordnet sind, wobei die beiden Lichtsender (25, 30) Licht auf den Reflektor (35) abstrahlen und die Lichtempfänger (15, 20) das vom Reflektor (35) reflektierte Licht des ihnen jeweils zugeordneten Lichtsenders (25, 30) empfangen, daß der Reflektor (35) konzentrisch zur Drehachse (5) eine Kodierspur aufweist und daß auf der Kodierspur die helleren Flächen (45) und die dunkleren Flächen (50) abwechselnd angeordnet sind.

8. Optischer Inkrementgeber (1) nach einem der Ansprüche 1 bis 7, dadurch gekennzeichnet, daß die Lichtsender (25, 30) und die Lichtempfänger (15, 20) so angeordnet sind, daß die Lichtempfänger (15, 20) nicht gleichzeitig an derselben Radialen zur Drehachse (5) des Inkrementrades (10) reflektiertes Licht detektieren.

9. Optischer Inkrementgeber (1) nach einem der Ansprüche 2 bis 8, dadurch gekennzeichnet, daß die Lichtsende-/-empfangseinheiten (55, 60) auf verschiedenen Radialen (65, 66) zur Drehachse (5) liegen.

10. Optischer Inkrementgeber (1) nach einem der vorherigen Ansprüche, dadurch gekennzeichnet, daß die helleren Flächen (45) und die dunkleren Flächen (50) auf das Inkrementrad (10) aufgedruckt sind.

11. Optischer Inkrementgeber (1) nach einem der vorherigen Ansprüche, dadurch gekennzeichnet, daß das Inkrementrad (10) zentrisch zur Drehachse (5) eine Bohrung (70) aufweist und daß in der Bohrung (70) eine vorzugsweise beleuchtbare Drucktaste (75) angeordnet ist, über die ein Druckkontakt (80) betätigbar ist.

12. Optischer Inkrementgeber (1) nach einem der Ansprüche 3 bis 11, dadurch gekennzeichnet, daß die helleren Flächen (45) und die dunkleren Flächen (50) einer Kodierspur jeweils gleich groß sind.
